(19)

**Europäisches Patentamt**
**European Patent Office**
**Office européen des brevets**

(11)  **EP 2 711 443 A1**

(12)  **EUROPEAN PATENT APPLICATION**

(43) Date of publication:
 **26.03.2014  Bulletin 2014/13**

(51) Int Cl.:
 *C23C 16/455* (2006.01)   *H01J 37/32* (2006.01)

(21) Application number: **13185183.4**

(22) Date of filing: **19.09.2013**

(84) Designated Contracting States:
 **AL AT BE BG CH CY CZ DE DK EE ES FI FR GB GR HR HU IE IS IT LI LT LU LV MC MK MT NL NO PL PT RO RS SE SI SK SM TR**
 Designated Extension States:
 **BA ME**

(30) Priority: **20.09.2012  KR 20120104309**

(71) Applicant: **Samsung Corning Precision Materials Co., Ltd.**
 **Gyeongsangbuk-do**
 **Gumi-si, 730-735 (KR)**

(72) Inventors:
 • **Lee, Joo Young**
  **336-841 Asan-si ChungCheongNam-Do (KR)**
 • **Yoo, Young Zo**
  **336-841 Asan-si ChungCheongNam-Do (KR)**

 • **Kim, Seo Hyun**
  **336-841 Asan-si ChungCheongNam-Do (KR)**
 • **Park, JeongWoo**
  **336-841 Asan-si ChungCheongNam-Do (KR)**
 • **Park, June Hyoung**
  **336-841 Asan-si ChungCheongNam-Do (KR)**
 • **Baek, Il Hee**
  **336-841 Asan-si ChungCheongNam-Do (KR)**
 • **Yoon, Gun Sang**
  **336-841 Asan-si ChungCheongNam-Do (KR)**
 • **Lee, Hyunhee**
  **336-841 Asan-si ChungCheongNam-Do (KR)**
 • **Choi, Eun Ho**
  **336-841 Asan-si ChungCheongNam-Do (KR)**

(74) Representative: **Gulde Hengelhaupt Ziebig & Schneider**
 **Patentanwälte - Rechtsanwälte**
 **Wallstraße 58/59**
 **D-10179 Berlin (DE)**

(54)  **Gas injector and injector pipe thereof**

(57)   A gas injector which can inject at a uniform velocity and an injector pipe used for the same. The gas injector includes a body, a gas flow path formed inside the body, the gas flow path extending from one end to the other end in a lengthwise direction of the body, a blade formed inside the body and connected to the gas flow path so as to inject gas, and an injector pipe inserted into the gas flow path. The injector pipe receives the gas from the gas supply, and distributes the gas through a plurality of holes to the gas flow path. The plurality of holes of the injector pipe include a plurality of first holes and a plurality of second holes which are formed along two parallel lines extending in the lengthwise direction of the injector pipe, the first holes alternating with the second holes.

FIG. 6

EP 2 711 443 A1

Description

CROSS REFERENCE TO RELATED APPLICATION

The present application claims priority from Korean Patent Application Number 10-2012-0104309 filed on September 20, 2012, the entire contents of which are incorporated herein for all purposes by this reference.

BACKGROUND OF THE INVENTION

Field of the Invention

The present invention relates to a gas injector and an injector pipe used for the same, and more particularly, to a gas injector which injects gas to a substrate during chemical vapor deposition (CVD) and an injector pipe used for the same.

Description of Related Art

Chemical vapor deposition (CVD) as well as physical vapor deposition (PVD) is a typical deposition method of forming a deposited film on a substrate.

CVD forms an intended deposition film on a substrate by heating and gasifying a source material that corresponds to a raw material and then feeding the gasified source material into a deposition chamber. In this process, energy required for forming the deposited film by heating the substrate to a certain temperature is supplied.

CVD has advantages in that the distribution and concentration of impurities can be controlled, the thickness of a film can be controlled (several to tens of nanometers), a deposited film can be formed on an insulator, and a substrate can be etched in situ.

In particular, atmospheric pressure chemical vapor deposition (APCVD) can significantly reduce the fabrication cost of products in mass production by, for example, enabling a continuous deposition process and precluding the use of a vacuum pump. In addition, another advantage is that a large area can be coated by APCVD.

In APCVD, important variables that are basically considered in order to produce a uniform deposited film may include the uniformity of the temperature of the substrate, the stability of the flow of a reaction substance, and the like.

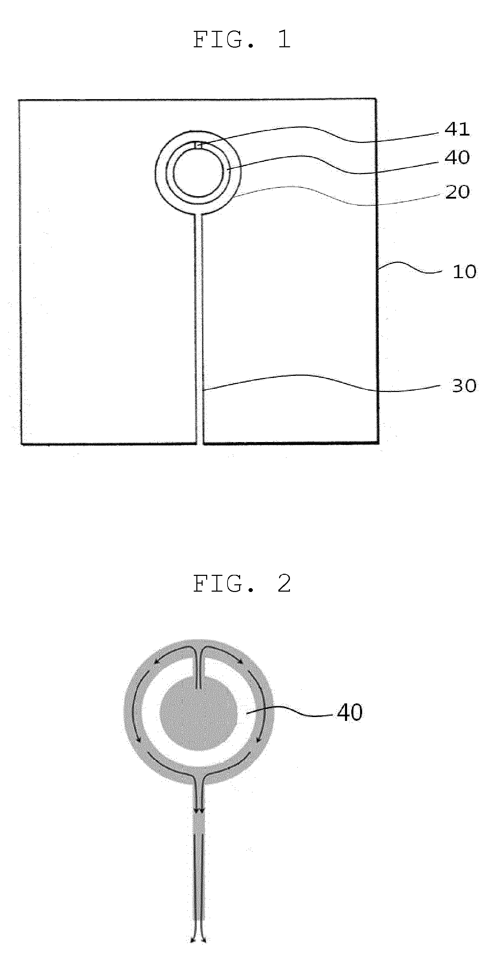

FIG. 1 is a schematic cross-sectional view showing a gas injector of the related art used in APCVD.

As shown in FIG. 1, the related-art gas injector used in APCVD includes a body 10, a gas flow path 20 formed inside the body, a blade 30 connected to the gas flow path 20 and an injector pipe 40 inserted into the gas flow path 20. Here, a reaction gas, or a component of a material that is to be deposited on the substrate, is fed through the injector pipe 40, distributed to the gas flow path 20 through a manifold 41 formed in the injector pipe 40, and then injected to the substrate through the blade 30. The injected reaction gas is then deposited on the substrate.

FIG. 2 is a conceptual view schematically showing the flow of reaction gas fed into the flow path in the related-art gas injector. The gray shadow portion in FIG. 2 indicates the path along which the reaction gas actually flows.

FIG. 3 is a schematic top-plan view of the injector pipe 40 used in the related-art gas injector.

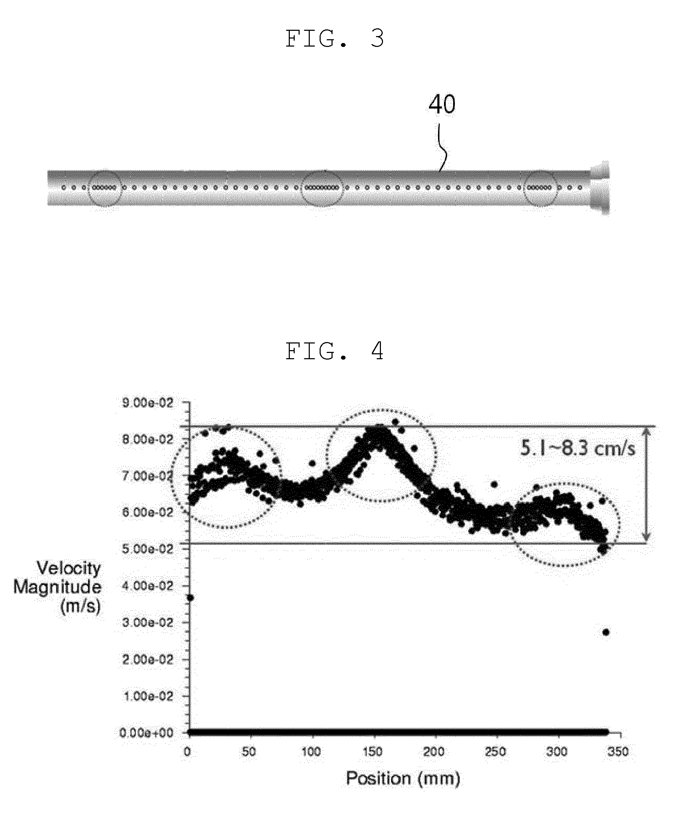

As shown in FIG. 3, the manifold formed in the injector pipe 40 is implemented as a plurality of holes arrayed in the lengthwise direction of the injector pipe. The holes are more densely formed in some portions of the injector pipe 40 (portions marked with red dotted lines in FIG. 3).

However, when the holes of the injector pipe 40 are formed in this fashion, the flow of the reaction gas injected from the gas injector becomes non-uniform.

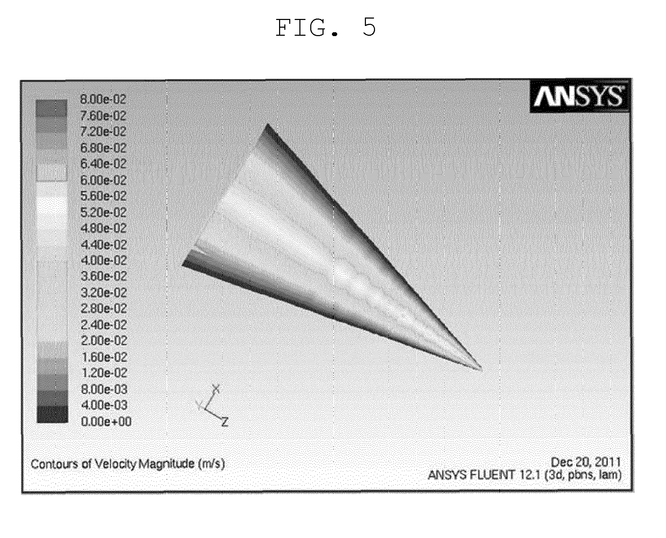

FIG. 4 and FIG. 5 are computational fluid dynamics simulation graphs performed on gas injected through the blade 30 in the related-art gas injector using ANSYS Fluent.

As shown in FIG. 4, it can be appreciated that gas injected from the related-art gas injector is non-uniformly injected with a maximum difference in the flow rate of about 3.2cm/s. In particular, the portions marked with the red dotted lines in FIG. 4 are identical with the portions in which the holes are densely formed in the injector pipe 40 (portions marked with red dotted lines).

This can also be confirmed from the graph shown in FIG. 5 in which the gas injected from the related-art injector has several sections.

When the gas is injected at non-uniform velocity, a non-uniform film is deposited on the substrate and the quality of the film is lowered, which is problematic.

The information disclosed in the Background of the Invention section is provided only for better understanding of the background of the invention, and should not be taken as an acknowledgment or any form of suggestion that this information forms a prior art that would already be known to a person skilled in the art.

## BRIEF SUMMARY OF THE INVENTION

Various aspects of the present invention provide a gas injector which can inject at a uniform velocity and an injector pipe used for the same.

In an aspect of the present invention, provided is a gas injector that includes: a body; a gas flow path formed inside the body, the gas flow path extending from one end to the other end in a lengthwise direction of the body; a blade formed inside the body and connected to the gas flow path so as to inject gas; and an injector pipe inserted into the gas flow path. The injector pipe receives the gas from the gas supply, and distributes the gas through a plurality of holes to the gas flow path. The plurality of holes of the injector pipe include a plurality of first holes and a plurality of second holes which are formed along two parallel lines extending in the lengthwise direction of the injector pipe, the first holes alternating with the second holes.

According to an exemplary embodiment of the present invention, the central angle defined by the plurality of first holes and the plurality of second holes about the center of the injector pipe may range from 0 to 120°.

The distance between the first holes and the distance between the second holes may decrease in the direction away from the gas supply. It is preferred that the distance between the first holes and the distance between the second holes decrease by a predetermined size in the direction away from the gas supply, the predetermined size ranging from 0.02 to 0.06mm.

The injector pipe may have the plurality of first holes and the plurality of second holes in the upper side that is opposite the lower side that faces the blade. (Here, the upper side and the lower side do not indicate the absolute positional relationship but a relative positional relationship. Therefore, it is possible to name the side that faces the blade as the upper side and its opposite side as the lower side.)

The total number of the first holes and the second holes may satisfy the formula:

$$1/3*\pi*R_{in}^2 \ < \ nA \ < \ 2/3*\pi*R_{in}^2,$$

where n is the total number of the first holes and the second holes, $R_{in}$ is an inner diameter of the injector pipe, and A is the cross-sectional area of the first and second holes.

The gas flow path may include a plurality of gas flow paths formed inside the body. The blade may include a plurality of blades each of which is connected to a corresponding gas flow path of the plurality of gas flow paths. The injector pipe may include a plurality of injector pipes each of which is inserted into a corresponding gas flow path of the plurality of gas flow paths.

The gas injector may further include a temperature controller which controls the temperature of the gas.

In another aspect of the present invention, provided is an injector pipe which receives gas from a gas supply and distributes the gas through a plurality of holes. The plurality of holes include a plurality of first holes and a plurality of second holes which are formed along two parallel lines extending in a longitudinal direction of the injector pipe, the first holes alternating with the second holes.

According to an exemplary embodiment of the present invention, the central angle defined by the plurality of first holes and the plurality of second holes about the center of the injector pipe may range from 0 to 120°.

The distance between the first holes and the distance between the second holes may decrease in the direction away from the gas supply.

The total number of the first holes and the second holes may satisfy the formula:

$$1/3*\pi*R_{in}^2 \ < \ nA \ < \ 2/3*\pi*R_{in}^2,$$

where n is the total number of the first holes and the second holes, $R_{in}$ is an inner diameter of the injector pipe, and A is the cross-sectional area of the first and second holes.

According to embodiments of the present invention, since a plurality of first holes and a plurality of second holes are formed along two parallel lines on the injector pipe such that the first holes alternate with the second holes, it is possible to uniformize the flow rate of gas injected from the gas injector and deposit a uniform film on a substrate.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

## BRIEF DESCRIPTION OF THE DRAWINGS

FIG. 1 is a schematic cross-sectional view showing a gas injector of the related art used in APCVD;

FIG. 2 is a conceptual view schematically showing the flow of reaction gas fed into the flow path in the related-art gas injector;

FIG. 3 is a schematic top-plan view of the injector pipe 40 used in the related-art gas injector;

FIG. 4 and FIG. 5 are computational fluid dynamics simulation graphs performed on gas injected through the blade 30 in the related-art gas injector using ANSYS Fluent;

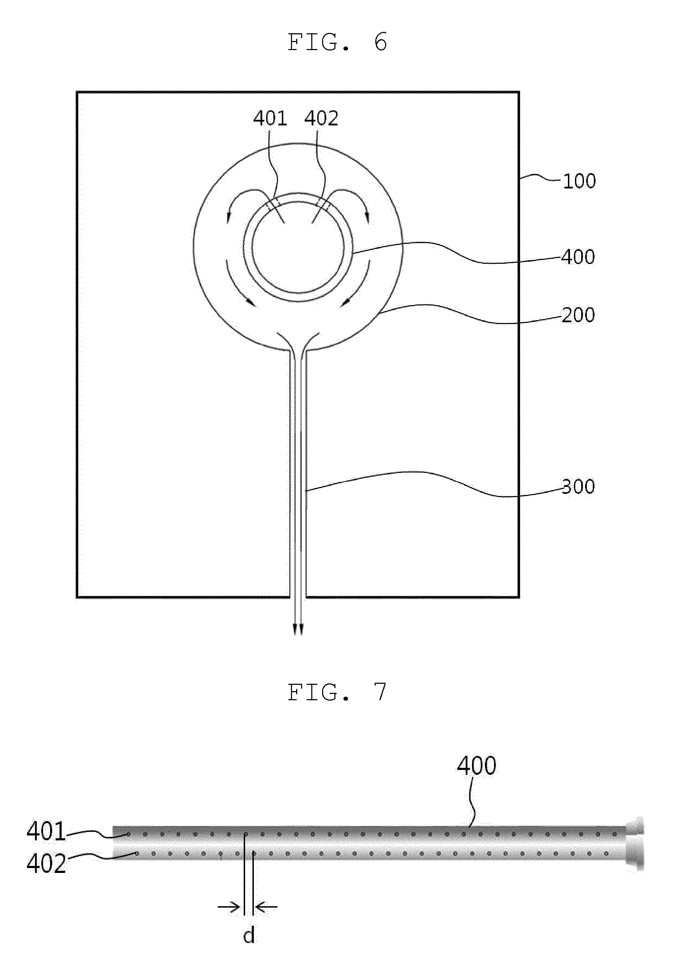

FIG. 6 is a cross-sectional view schematically showing a gas injector according to an embodiment of the present invention;

FIG. 7 is a top-plan view of an injector pipe according to an embodiment of the present invention;

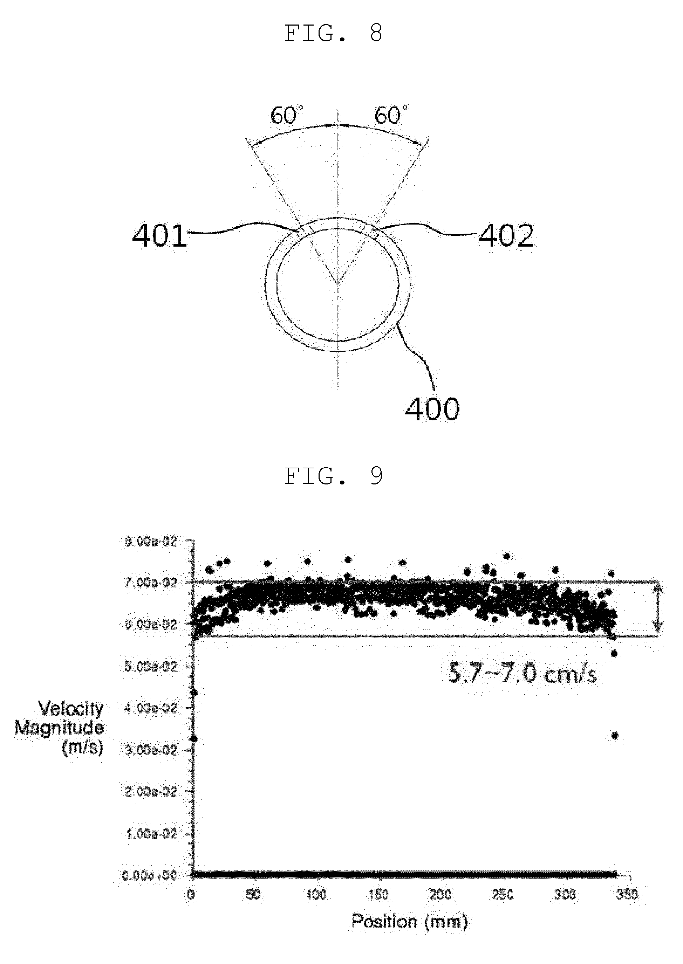

FIG. 8 is a cross-sectional view of the injector pipe showing an angle included between the line of first holes and the line of second holes according to an embodiment of the invention;

FIG. 9 to FIG. 13 are computational fluid dynamics simulation graphs performed on gas injected through the gas injector according to an embodiment of the present invention using ANSYS Fluent; and

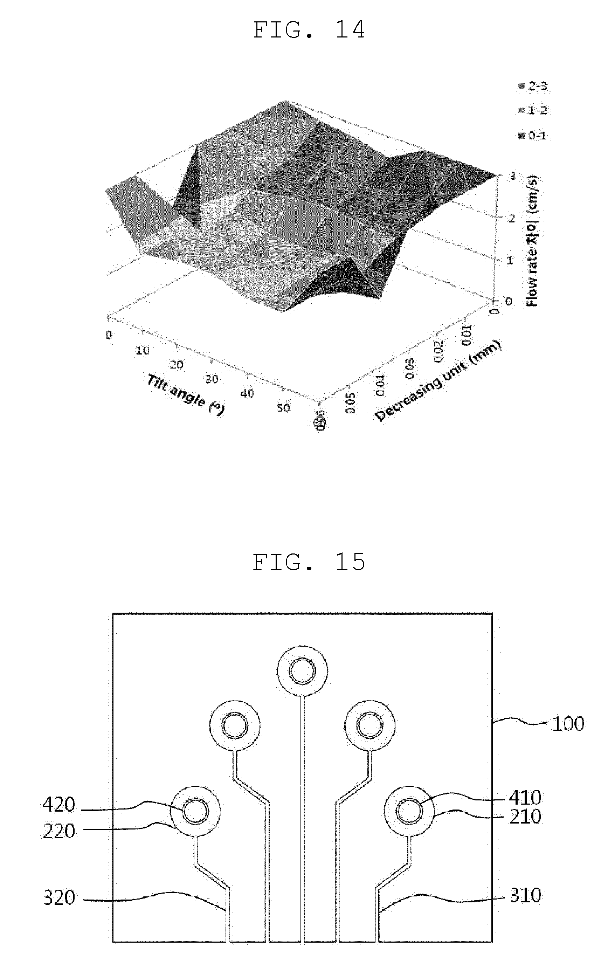

FIG. 14 is a three-dimensional graph of Table 1; and

FIG. 15 is a schematic cross-sectional view showing a gas injector according to another embodiment of the present invention.

## DETAILED DESCRIPTION OF THE INVENTION

Reference will now be made in detail to a gas injector and an injector pipe used for the same according to the present invention, embodiments of which are illustrated in the accompanying drawings and described below, so that a person having ordinary skill in the art to which the present invention relates can easily put the present invention into practice.

Throughout this document, reference should be made to the drawings, in which the same reference numerals and signs are used throughout the different drawings to designate the same or similar components. In the following description of the present invention, detailed descriptions of known functions and components incorporated herein will be omitted when they may make the subject matter of the present invention unclear.

FIG. 6 is a cross-sectional view schematically showing a gas injector according to an embodiment of the present invention.

Referring to FIG. 6, the gas injector according to an embodiment of the present invention includes a body 100, a gas flow path 200, a blade 300 and an injector pipe 400.

The body 100 forms the contour of the gas injector, and can be implemented as a block having a rectangular parallelepiped shape.

The body 100 is positioned in the upper part of a chamber in which a deposition process is carried out, and a substrate on which a film is to be deposited is positioned below the body 100.

The gas flow path 200 is formed inside the body 100, and extends from one end to the other end of the body 100 in the lengthwise direction of the body 100. The injector pipe 400 is inserted into the glass flow path 200, and the gas flow path 200 allows gas distributed from the injector pipe 400 to flow toward the blade 300.

One end of the gas flow path 200 is closed. In addition, a seal is provided between the other end of the gas flow path 200 through which the injector pipe 400 is inserted and the injector pipe 400 such that the gas does not leak.

It is preferred that the gas flow path 200 be cylindrical.

The blade 300 is formed inside the body 100, and is connected to the gas flow path 200. The blade 300 is configured such that it injects the gas from the gas flow path 200 toward the substrate.

The gas that has been injected to the substrate through the blade 300 forms a deposited film on the substrate that is positioned inside the chamber.

The injector pipe 400 is inserted into the gas flow path 200, and is configured such that it distributes the gas supplied from a gas supply (not shown) to a plurality of gas flow paths 200 through a plurality of holes formed in the injector pipe 400. Here, it is possible to control the flow of the gas and the flow rate of the gas by adjusting the size, positions of the holes and the distance between the holes.

The outer circumference of the injector pipe 400 and the inner circumference of the gas flow path 200 are distanced from each other, thereby forming a space therebetween through which the gas distributed from the injector flows to the blade 300.

FIG. 7 is a top-plan view of the injector pipe 400 according to an embodiment of the present invention.

Referring to FIG. 7, according to an embodiment of the present invention, the plurality of holes in the injector pipe 400 include a plurality of first holes 401 and a plurality of second holes 402 which are formed along two parallel lines extending in the lengthwise direction of the injector pipe 400. The first holes 401 and the second holes 402 are formed such that the first holes 401 alternate with the second holes 402. That is, the first holes 401 and the second holes 402 are formed at positions that are tilted toward the left and right at certain angles about a reference point such that the first and second holes 401 and 402 form a zigzag shape. It is preferred that the first holes 401 and the second holes 402 be formed at positions that are tilted toward the left and right at the same angle about the reference point of the injector pipe 400. Here, the reference point is the antipodal point of the blade.

As such, the plurality of first holes 401 and the plurality of second holes 402 are formed along the two parallel lines such that the first holes 401 alternate with the second holes 402. It is therefore possible to uniformize the flow rate of the gas injected through the blade 300, whereby a uniform film can be deposited on the substrate.

The central angle defined by the plurality of first holes 401 and the plurality of second holes 402 about the center of the injector pipe 400 (i.e. the angle defined by the line that connects the plurality of first holes to the center of the injector pipe and the line that connects the plurality of the second holes to the center of the injector pipe) is smaller than 180°. As shown in FIG. 8, the central angle can be 120°.

In addition, it is preferred that the distance between the first holes 401 decrease in the direction away from the gas supply. More preferably, the distance between the first holes 401 decreases by a certain size in the direction away from the gas supply. Here, the certain size ranges from 0.02 to 0.06 mm. In addition, the distance between the first holes 401 and the distance between the second holes 402 can decrease in arithmetic progression or progression of differences.

In addition, it is preferred that the total number of the first holes 401 and the second holes 402 according to the present invention be set to satisfy the following formula:

$$1/3*\pi*R_{in}^{2} < nA < 2/3*\pi*R_{in}^{2},$$

where n is the total number of the first holes and the second holes, $R_{in}$ is the inner diameter of the injector pipe, and A is a cross-sectional area of the first and second holes.

It is possible to calculate the distance between the holes using this formula.

In addition, the injector pipe can have the plurality of first holes 401 and the plurality of second holes 402 in the upper side that is opposite the lower side that faces the blade 300. Consequently, after the gas distributed from the injector pipe has flown along the inside of the gas flow path 200 for a certain time, it can be injected through the blade 300 toward the substrate, thereby reducing the flow rate of the gas more or less. It is therefore possible to improve the efficiency at which the gas is deposited on the substrate and the uniformity of the film that is deposited on the substrate. It addition, it is possible to increase the straightness of the gas injected from the blade 300.

The injector pipe 400 according to the present invention can be replaced. That is, when another injector pipe having a different hole size or different distance between the holes is required to be used or some holes of the injector pipe are closed, it is possible to separate only the injector pipe from the gas injector and put a new injector pipe in place.

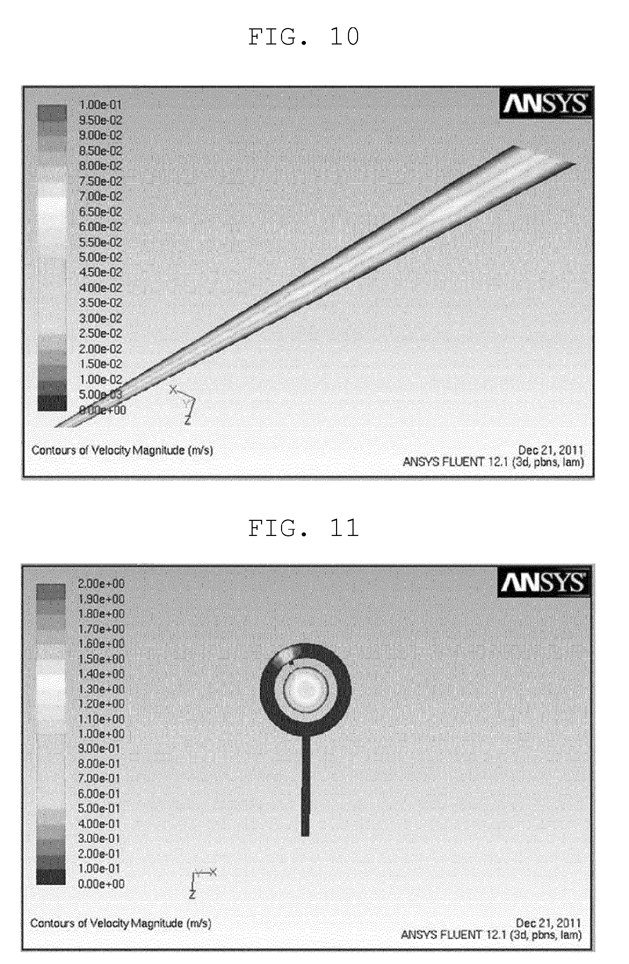

FIG. 9 and FIG. 10 are computational fluid dynamics simulation graphs performed on gas injected through the gas injector of the present invention using ANSYS Fluent.

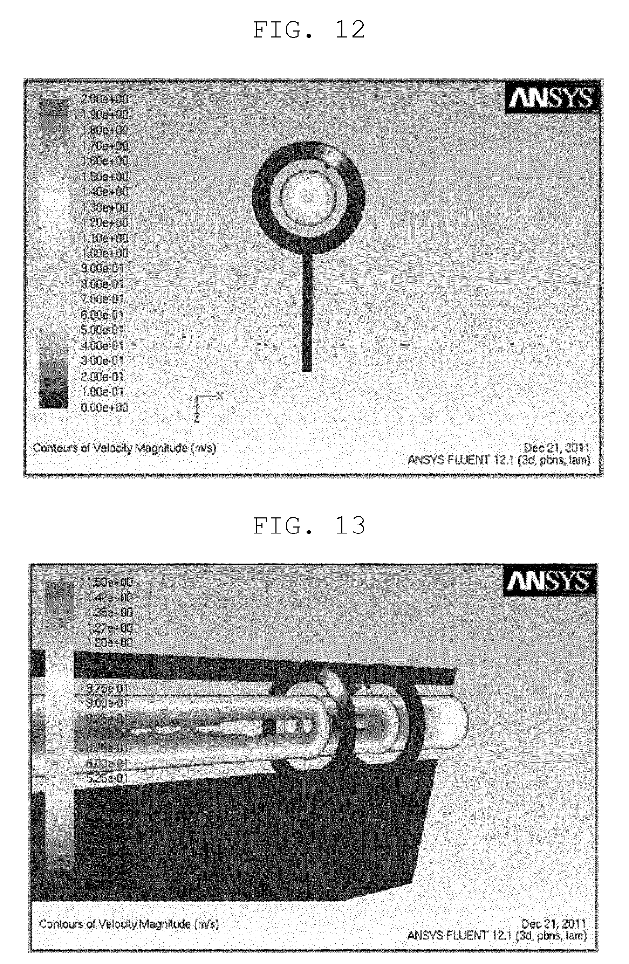

In addition, FIG. 11 is a computational fluid dynamics simulation graph performed on the cross-section of the portion corresponding to the first hole 401 using ANSYS Fluent, FIG. 12 is a computational fluid dynamics simulation graph performed on the cross-section of the portion corresponding to the second hole 402 using ANSYS Fluent, and FIG. 13 is a computational fluid dynamics simulation graph performed on the portion including the portions in FIG. 11 and FIG. 12 using ANSYS Fluent.

In the injector pipe 400 used in the computational fluid dynamics simulations shown in FIG. 9 to FIG. 13, the plurality of first holes 401 and the plurality of the second holes 402 are formed in the upper side of the injector pipe 400 that is opposite the lower side that faces the blade 300 such that the first holes 401 alternate with the second holes 402 at certain distances, with the central angle defined by the plurality of first holes 401 and the plurality of second holes 402 about the center of the injector pipe 400 being 120°.

As shown in FIG. 9, when the gas is injected by the gas injector of the present invention, the maximum and the minimum of the flow rates of the gas are 7.0cm/s and 5.7cm/s, and the difference between the maximum and the minimum is merely 1.3cm/s. Accordingly, in the gas injector of the present invention, the difference in the gas flow rate is more greatly reduced than that of the related-art gas injector. It is also apparent that the overall flow rate of the gas is more uniformized. This can also be appreciated from the graph shown in FIG. 10 in which the sections present in the gas injected from the gas injector of the present invention are significantly reduced or removed compared to FIG. 5.

Table 1 presents a computational fluid dynamics simulation performed on the differences (cm/s) between the maximum flow rate and the minimum flow rate of gas injected through the blade, in which the simulation is performed using ANSYS Fluent by setting the distance d between the line of first holes 401 and the line of second holes 402 to 7mm, varying the positions of the first holes 401 and the second holes 402, and varying the reduced size of the distance between the first holes 401 and between the second holes 402. FIG. 14 is a three-dimensional graph of Table 1. Here, the reference point of the tilt angle is the antipodal point of the blade 300.

Table 1

| RS[1] (mm) TA[2] (°) | 0 | 0.01 | 0.02 | 0.03 | 0.04 | 0.05 | 0.06 |
|---|---|---|---|---|---|---|---|
| 0 | | | | | 1.6 | | |
| 10 | 2.8 | 2.25 | 2.15 | 1.75 | 1.55 | 1.8 | 1.8 |
| 20 | 2.7 | 2.4 | 2.05 | 1.5 | 1.4 | 1.7 | 2 |
| 30 | 2.5 | 2.2 | 2 | 1.45 | 1.3 | 1.75 | 2 |
| 40 | 3 | 2.3 | 2.05 | 1.6 | 1.55 | 1.45 | 1.75 |
| 50 | | 2.6 | 2.05 | 1.8 | 1.45 | 1.75 | 1.75 |
| 60 | | | | | 1.6 | | |

Note)

RS[1]: Reduced size, TA[2]: tilt angle

Referring to Table 1 and FIG. 14, it can be appreciated that, when the reduced size of the distance between the first holes 401 and the between the second holes 402 range from 0.02 to 0.06mm and the tilt angles of the first holes 401 and the second holes 402 about the reference point of the injector pipe 400 range from 0 to 60° (the reference point is the antipodal point of the blade), the difference between the maximum flow rate and the minimum flow rate of the gas injected through the blade 300 is reduced to be 2.15cm/s or less. Furthermore, the values marked with the shade in Table 1 show that the effect of reducing the difference in the flow rate of the gas injected through the blade is improved at least twice compared to the gas injector of the related art.

In addition, the gas injector according to the present invention can further include a temperature controller (not shown) which improves deposition efficiency by controlling the temperature of gas that is injected.

The temperature controller (not shown) can control the temperature of gas that is injected to the substrate by circulating liquid or gas through the inside of the gas injector.

FIG. 15 is a schematic cross-sectional view showing a gas injector according to another embodiment of the present invention.

Referring to FIG. 15, the gas injector according to the present invention includes a plurality of gas flow paths 210 and 220 formed inside a body 100, blades 310 and 320 each of which is connected to a corresponding gas flow path of the gas flow paths 210 and 220, and injector pipes 410 and 420 each of which is inserted into a corresponding gas flow path of the gas flow paths 210 and 220.

When several kinds of gases are required to deposit a film on a substrate, individual gases can be injected to the substrate by being separated from each other through the plurality of gas flow paths 210 and 220, the blades 310 and 320 and the injector pipes 410 and 420 so that the gases neither prematurely mix nor react with each other inside the gas injector.

This can consequently help the gases injected from the gas injector react perfectly, efficiently and uniformly on the substrate, thereby improving the quality of the film deposited on the substrate.

The foregoing descriptions of specific exemplary embodiments of the present invention have been presented with respect to the drawings. They are not intended to be exhaustive or to limit the present invention to the precise forms disclosed, and obviously many modifications and variations are possible for a person having ordinary skill in the art in light of the above teachings.

It is intended therefore that the scope of the present invention not be limited to the foregoing embodiments, but be defined by the Claims appended hereto and their equivalents.

**Claims**

1. An injector pipe which receives gas from a gas supply and distributes the gas through a plurality of holes, wherein the plurality of holes include a plurality of first holes and a plurality of second holes which are formed along two parallel lines extending in a lengthwise direction of the injector pipe, the first holes alternating with the second holes.

2. The injector pipe of claim 1, wherein a central angle defined by the plurality of first holes and the plurality of second holes about a center of the injector pipe ranges 0 to 120°.

3. The injector pipe of claim 2, wherein a distance between adjacent first holes of the plurality of first holes and a distance between adjacent second holes of the plurality of second holes decrease in a direction away from the gas supply.

4. The injector pipe of claim 1, wherein a total number of the first holes and the second holes satisfies the formula:

$$1/3*\pi*R_{in}^2 \ < \ nA \ < \ 2/3*\pi*R_{in}^2,$$

where n is the total number of the first holes and the second holes, $R_{in}$ is an inner diameter of the injector pipe, and A is a cross-sectional area of the first and second holes.

5. A gas injector comprising:

   a body;
   a gas flow path formed inside the body, the gas flow path extending from one end to the other end in a lengthwise direction of the body;
   the injector pipe recited in claim 1, the injector pipe being inserted into the gas flow path; and
   a blade formed inside the body and connected to the gas flow path,
   wherein the injector pipe receives the gas from the gas supply, and distributes the gas through the plurality of holes to the gas flow path, and the blade connected to the gas flow path injects the gas.

6. The gas injector of claim 5, wherein a central angle defined by the plurality of first holes and the plurality of second holes about a center of the injector pipe ranges from 0 to 120°.

7. The gas injector of claim 6, wherein a distance between adjacent first holes of the plurality of first holes and a distance between adjacent second holes decrease of the plurality of second holes in a direction away from the gas supply.

8. The gas injector of claim 7, wherein the distance between the adjacent first holes and the distance between the adjacent second holes decrease by a predetermined size in the direction away from the gas supply, the predetermined size ranging from 0.02 to 0.06mm.

9. The gas injector of claim 5, wherein the injector pipe comprises the plurality of first holes and the plurality of second holes in an upper side that is opposite the lower side that faces the blade.

10. The gas injector of claim 5, wherein a total number of the first holes and the second holes satisfies the formula:

$$1/3*\pi*R_{in}^2 \ < \ nA \ < \ 2/3*\pi*R_{in}^2,$$

where n is the total number of the first holes and the second holes, $R_{in}$ is an inner diameter of the injector pipe, and A is a cross-sectional area of the first and second holes.

11. The gas injector of claim 5, wherein
the gas flow path comprises a plurality of gas flow paths formed inside the body,
the blade comprises a plurality of blades each of which is connected to a corresponding gas flow path of the plurality of gas flow paths, and
the injector pipe comprises a plurality of injector pipes each of which is inserted into a corresponding gas flow path of the plurality of gas flow paths.

**12.** The gas injector of claim 5, further comprising a temperature controller which controls a temperature of the gas.

FIG. 1

FIG. 2

FIG. 3

40

FIG. 4

FIG. 5

Contours of Velocity Magnitude (m/s)

Dec 20, 2011
ANSYS FLUENT 12.1 (3d, pbns, lam)

FIG. 6

FIG. 7

FIG. 8

FIG. 9

## FIG. 10

Contours of Velocity Magnitude (m/s)

Dec 21, 2011
ANSYS FLUENT 12.1 (3d, pbns, lam)

## FIG. 11

Contours of Velocity Magnitude (m/s)

Dec 21, 2011
ANSYS FLUENT 12.1 (3d, pbns, lam)

FIG. 12

FIG. 13

# FIG. 14

# FIG. 15

**EUROPEAN SEARCH REPORT**

Application Number

EP 13 18 5183

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 146 461 A (YANG CHANG-ZIP [KR] ET AL) 14 November 2000 (2000-11-14) | 1-3 | INV.<br>C23C16/455<br>H01J37/32 |
| Y | * col. 3, l. 57-61; figures 5, 6 * | 7,8 | |
| X | US 2009/159432 A1 (KAWANO SHINGO [JP] ET AL) 25 June 2009 (2009-06-25) | 4-6,9, 10,12 | |
| Y | * paragraphs [0078], [0080], [0086], [0092] - [0099]; figures 7A, 7B, 8, 9 * | 7,8 | |
| X | US 2002/134507 A1 (DEDONTNEY JAY BRIAN [US] ET AL) 26 September 2002 (2002-09-26) * figure 8 * | 11 | |
| X | US 2008/102222 A1 (FUJINAWA JUN [JP] ET AL) 1 May 2008 (2008-05-01) * figure 3b * | 1,2 | |
| Y | JP H05 132764 A (ULVAC CORP) 28 May 1993 (1993-05-28) * paragraphs [0013], [0025], [0028]; claim 2; figures 3,4 * | 7,8 | |

TECHNICAL FIELDS
SEARCHED (IPC)

C23C
H01J

The present search report has been drawn up for all claims

| Place of search | Date of completion of the search | Examiner |
|---|---|---|
| The Hague | 25 November 2013 | Peijzel, Paul |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 13 18 5183

This annex lists the patent family members relating to the patent documents cited in the above-mentioned European search report.
The members are as contained in the European Patent Office EDP file on
The European Patent Office is in no way liable for these particulars which are merely given for the purpose of information.

25-11-2013

| Patent document cited in search report | | Publication date | Patent family member(s) | | Publication date |
|---|---|---|---|---|---|
| US 6146461 | A | 14-11-2000 | JP | 2001102306 A | 13-04-2001 |
| | | | KR | 20010028032 A | 06-04-2001 |
| | | | US | 6146461 A | 14-11-2000 |
| US 2009159432 | A1 | 25-06-2009 | CN | 101467233 A | 24-06-2009 |
| | | | EP | 2058845 A1 | 13-05-2009 |
| | | | JP | 4745920 B2 | 10-08-2011 |
| | | | JP | 2008053650 A | 06-03-2008 |
| | | | KR | 20090011007 A | 30-01-2009 |
| | | | US | 2009159432 A1 | 25-06-2009 |
| | | | WO | 2008026491 A1 | 06-03-2008 |
| US 2002134507 | A1 | 26-09-2002 | CN | 1397755 A | 19-02-2003 |
| | | | DE | 60201383 D1 | 04-11-2004 |
| | | | DE | 60201383 T2 | 16-02-2006 |
| | | | EP | 1276031 A1 | 15-01-2003 |
| | | | JP | 3621393 B2 | 16-02-2005 |
| | | | JP | 2003130280 A | 08-05-2003 |
| | | | KR | 20030007162 A | 23-01-2003 |
| | | | SG | 115486 A1 | 28-10-2005 |
| | | | TW | I240017 B | 21-09-2005 |
| | | | US | 2002134507 A1 | 26-09-2002 |
| US 2008102222 | A1 | 01-05-2008 | JP | 5291875 B2 | 18-09-2013 |
| | | | JP | 2008115412 A | 22-05-2008 |
| | | | US | 2008102222 A1 | 01-05-2008 |
| JP H05132764 | A | 28-05-1993 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020120104309